# EUROPÄISCHE PATENTANMELDUNG

(11) **EP 2 439 306 A1**
(43) Veröffentlichungstag der Anmeldung: **11.04.2012**
(21) Anmeldenummer: 11184281.1
(22) Anmeldetag: 07.10.2011
(51) Int. Cl.: C23C 4/02, C23C 4/12, C23C 28/00, C23C 14/08

(54) **Verfahren zum Herstellen eines Wärmedämmschichtaufbaus**

(30) Priorität: 11.10.2010 EP 10187182
(71) Anmelder: Sulzer Metco AG, 5610 Wohlen (CH)
(72) Erfinder: von Niessen, Konstantin, 5632 Buttwil (CH); Gindrat, Malko, 5610 Wohlen (CH); Schmid, Richard C., 8500 Gerlikon (CH)
(74) Vertreter: Sulzer Management AG

(57) **Zusammenfassung**

Zum Herstellen eines Wärmedämmschichtaufbaus (10) auf einer Substratoberfläche wird eine Arbeitskammer (2) mit einem Plasmabrenner (4) zur Verfügung gestellt, ein Plasmastrahl (5) erzeugt, indem ein Plasmagas durch den Plasmabrenner (4) geleitet und in demselben mittels elektrischer Gasentladung, elektromagnetischer Induktion oder Mikrowellen aufgeheizt wird, und der Plasmastrahl (5) auf die Oberfläche eines in die Arbeitskammer eingebrachten Substrates (3) gelenkt. Zum Herstellen des Wärmedämmschichtaufbaus wird zusätzlich zwischen dem Plasmabrenner (4) und dem Substrat (3) eine Spannung angelegt, um zwischen dem Plasmabrenner (4) und dem Substrat (3) einen Lichtbogen zu erzeugen, und die Substratoberfläche mittels des Lichtbogens gereinigt, wobei das Substrat (3) nach dem Lichtbogenreinigen in der Arbeitskammer verbleibt, und auf der gereinigten Substratoberfläche eine Oxidschicht (11) mit einer Dicke von 0.02 µm bis 2 µm erzeugt und in einem weiteren Schritt mittels eines Plasmaspritzverfahrens eine Wärmedämmschicht (12) aufgebracht.

## Beschreibung

Die Erfindung betrifft ein Verfahren zum Herstellen eines Wärmedämmschichtaufbaus auf einer Substratoberfläche gemäss Oberbegriff von Anspruch 1 und ein Substrat, hergestellt mit einem derartigen Verfahren.

In Maschinen und Prozessen werden Wärmedämmschichtsysteme eingesetzt, um thermisch stark beanspruchte Teile gegen die Einwirkung von Hitze, Heissgaskorrosion und Erosion zu schützen. Häufig ist eine Steigerung des Wirkungsgrades von Maschinen und Prozessen nur mit einer Erhöhung der Prozesstemperatur möglich, so dass exponierte Teile entsprechend geschützt werden müssen. So werden beispielsweise die Turbinenschaufeln in Flugzeugtriebwerken und stationären Gasturbinen normalerweise mit einem ein- oder mehrlagigen Wärmedämmschichtsystem versehen, um die Turbinenschaufeln gegen die Einwirkung der hohen Prozesstemperaturen zu schützen und die Wartungsintervalle und Lebensdauer zu verlängern.

Ein Wärmedämmschichtsystem kann abhängig von der Anwendung eine oder mehrere Schichten enthalten, beispielsweise eine Sperrschicht, insbesondere Diffusionssperrschicht, eine Haftvermittlungsschicht, eine Heissgaskorrosionsschutzschicht, eine Schutzschicht, eine Wärmedämmschicht und/oder eine Deckschicht. Im Beispiel der oben erwähnten Turbinenschaufeln ist das Substrat meist aus einer Ni- oder Co-Legierung hergestellt. Das auf der Turbinenschaufel aufgebrachte Wärmedämmschichtsystem kann zum Beispiel in aufsteigender Reihenfolge folgende Schichten enthalten:
- eine metallische Sperrschicht, zum Beispiel aus NiAl- oder NiCr- Phasen oder Legierungen,
- eine metallische Haftvermittlungsschicht, die auch als Heissgaskorrosionsschutzschicht dient, und die zum Beispiel mindestens teilweise aus einem Metallaluminid oder aus einer MCrAIY-Legierung hergestellt sein kann, wobei M eines der Metalle Fe, Ni oder Co oder eine Kombination von Ni und Co bedeutet,
- eine oxidkeramische Schutzschicht, zum Beispiel zur Hauptsache aus Al₂O₃ oder aus anderen Oxiden,
- eine oxidkeramische Wärmedämmschicht, zum Beispiel aus stabilisiertem Zirkonoxid, und
- eine oxidkeramische Glättungs- oder Deckschicht, zum Beispiel aus stabilisiertem Zirkonoxid oder SiO₂.

Der Wärmedämmschichtaufbau, dessen Herstellung im Folgenden beschrieben wird, enthält mindestens eine oxidkeramische Schutzschicht und mindestens eine oxidkeramische Wärmedämmschicht. Dieser Wärmedämmschichtaufbau wird auf eine metallische Substratoberfläche aufgebracht, die wie im Beispiel der oben erwähnten Turbinenschaufel durch eine metallische Haftvermittlungs- und/oder Heissgaskorrosionsschutzschicht gegeben sein kann.

In Dokument US 5 238 752 ist die Herstellung eines Wärmedämmschichtaufbaus beschrieben, der auf eine metallische Substratoberfläche aufgebracht wird. Das Substrat selbst besteht aus einer Ni- oder Co-Legierung, während die metallische Substratoberfläche durch eine 25 µm bis 125 µm dicke Haftvermittlungsschicht aus Ni- oder Pt-Aluminid gebildet wird. Auf dieser Substratoberfläche wird durch thermische Oxidation eine oxidkeramische, 0.03 µm bis 3 µm dicke Schutzschicht aus Al₂O₃ erzeugt und anschliessend mittels Electron Beam - Physical Vapor Deposition (EB-PVD) eine oxidkeramische, 125 µm bis 725 µm dicke Wärmedämmschicht aus ZrO₂ und 6% - 20% Y₂O₃ abgeschieden. Beim EB-PVD-Verfahren wird die für die Wärmedämmschicht abzuscheidende Substanz, z.B. ZrO₂ mit 8% Y₂O₃ in einem Hochvakuum mit einem Elektronenstrahl in die Dampfphase gebracht und aus dieser auf dem zu beschichtenden Bauteil auskondensiert. Werden die Prozessparameter geeignet gewählt, so ergibt sich eine kolumnare Mikrostruktur.

Die in US 5 238 752 beschriebene Herstellung eines Wärmedämmschichtaufbaus hat den Nachteil, dass die Anlagekosten für das Abscheiden der Wärmedämmschicht mittels EB-PVD vergleichsweise hoch sind, und dass EB-PVD keinen "Non Line Of Sight" (NLOS)-Auftrag der Wärmedämmschicht erlaubt, während es zum Beispiel beim Low Pressure Plasma Spraying (LPPS) möglich ist, auch Teile des Substrats zu beschichten, die hinter einer Kante liegen und vom Plasmabrenner aus nicht sichtbar sind.

Aus WO 03/087422 A1 ist bekannt, dass Wärmedämmschichten mit einer kolumnaren Struktur auch mittels eines LPPS-Dünnfilm-Verfahrens herstellbar sind. In dem in WO 03/087422 A1 beschriebenen Plasmaspritzverfahren wird ein zu beschichtendes Material mittels eines Plasmastrahls auf eine Oberfläche eines metallischen Substrats aufgespritzt. Dabei wird bei einem niedrigen Prozessdruck, der kleiner als 10 kPa ist, das Beschichtungsmaterial in ein den Pulverstrahl defokussierendes Plasma injiziert und dort teilweise oder vollständig geschmolzen. Hierzu wird ein Plasma mit ausreichend hoher spezifischer Enthalpie erzeugt, so dass ein substantieller, mindestens 5 Gewichts-% betragender Anteil des Beschichtungsmaterials in die Dampfphase übergeht. Auf dem Substrat wird mit dem Beschichtungsmaterial eine anisotrope strukturierte Schicht aufgetragen. In dieser Schicht sind längliche Korpuskeln, die eine anisotrope Mikrostrukturen bilden, weitgehend senkrecht zur Substratoberfläche stehend ausgerichtet, wobei die Korpuskeln durch materialarme Übergangsbereiche gegeneinander abgegrenzt sind, und mithin eine kolumnare Struktur aufweisen.

Das in WO 03/087422 A1 beschriebenen Plasmaspritzverfahren zum Herstellen von Wärmedämmschichten mit kolumnarer Struktur wird im Zusammenhang mit LPPS-Dünnfilm-Verfahren erwähnt, da es wie dieselben einen breiten Plasmastrahl verwendet, der durch die Druckdifferenz zwischen dem Druck im Innern des Plasmabrenners von typisch 100 kPa und dem Druck in der Arbeitskammer von weniger als 10kPa entsteht. Da die mit dem beschriebenen Verfahren erzeugten Wärmedämmschichten jedoch bis zu 1 mm dick oder dicker sein können und damit kaum unter den Begriff "Dünnfilm" fallen, wird das beschriebene Verfahren im Folgenden als Plasma Spray - Physical Vapor Deposition-Verfahren oder kurz PS-PVD-Verfahren bezeichnet.

Die Anmelderin hat festgestellt, dass die Temperaturwechselbeständigkeit von Wärmedämmschichtsystemen, die eine gemäss WO 03/087422 A1 hergestellte Wärmedämmschicht enthalten, verbessert werden kann, wenn ein nach einem modifizierten Verfahren hergestellter Wärmedämmschichtaufbau verwendet wird.

Aufgabe der Erfindung ist es, ein Verfahren zum Herstellen eines Wärmedämmschichtaufbaus auf einer Substratoberfläche zur Verfügung zu stellen, mit dem die Temperaturwechselbeständigkeit von Wärmedämmschichtsystemen mit Wärmedämmschichten, die mittels eines Plasmaspritzverfahrens hergestellten sind, verbessert werden kann.

Diese Aufgabe wird erfindungsgemäss durch das in Anspruch 1 definierte Verfahren gelöst.

In dem erfindungsgemässe Verfahren zum Herstellen eines Wärmedämmschichtaufbaus auf einer Substratoberfläche wird eine Arbeitskammer mit einem Plasmabrenner zur Verfügung gestellt, ein Plasmastrahl erzeugt, indem ein Plasmagas durch den Plasmabrenner geleitet und in demselben mittels elektrischer Gasentladung und/oder elektromagnetischer Induktion und/oder Mikrowellen aufgeheizt wird, und der Plasmastrahl auf die Oberfläche eines in die Arbeitskammer eingebrachten Substrates gelenkt. In dem Verfahren zum Herstellen eines Wärmedämmschichtaufbaus wird zusätzlich zwischen dem Plasmabrenner und dem Substrat eine Spannung angelegt, um zwischen dem Plasmabrenner und dem Substrat einen Lichtbogen zu erzeugen, und die Substratoberfläche mittels des Lichtbogens gereinigt, wobei das Substrat nach dem Lichtbogenreinigen in der Arbeitskammer verbleibt. Auf der derart gereinigten Substratoberfläche wird eine Oxidschicht mit einer Dicke von 0.02 µm bis 5 µm oder 0.02 µm bis 2 µm erzeugt und in einem weiteren Schritt mittels eines Plasmaspritzverfahrens mindestens eine Wärmedämmschicht aufgebracht. Vorteilhafterweise verbleibt das Substrat während dem Herstellen des Wärmedämmschichtaufbaus, typisch während der Dauer des gesamten Verfahrens, in der Arbeitskammer.

Typisch ist das Substrat und/oder die Substratoberfläche metallisch, wobei die Substratoberfläche beispielsweise durch eine Haftvermittlerschicht und/oder Heissgaskorrosionsschutzschicht, zum Beispiel eine Schicht aus einem Metallaluminid wie NiAl, NiPtAl oder PtAl oder einer Legierung des Typs MCrAlY, mit M = Fe, Co, Ni oder NiCo, gebildet werden kann. Bei Bedarf können die Haftvermittlerschicht und/oder Heissgaskorrosionsschutzschicht vor dem oben stehend beschriebenen Wärmedämmschichtaufbau mittels eines Plasmaspritzverfahrens oder eines anderen geeigneten Verfahrens auf die Substratoberfläche aufgebracht werden.

In einer vorteilhaften Ausführungsform werden während dem Herstellen des Wärmedämmschichtaufbaus die Zusammensetzung und/oder der Druck der Atmosphäre in der Arbeitskammer kontrolliert und/oder gesteuert. In einer vorteilhaften Ausführungsvariante beträgt der Druck in der Arbeitskammer während des Lichtbogenreinigens der Substratoberfläche weniger als 1 kPa.

In einer weiteren vorteilhaften Ausführungsvariante enthält die Arbeitskammer während der Erzeugung der Oxidschicht Sauerstoff oder ein Sauerstoff enthaltendes Gas. Die Oxidschicht kann beispielsweise thermisch erzeugt werden, indem die Substratoberfläche zum Beispiel durch den Plasmastrahl erwärmt wird.

Die Oxidschicht kann auch mittels PS-PVD oder mittels eines chemischen Prozesses erzeugt werden, beispielsweise mittels Plasma Spray - Chemical Vapor Deposition (PS-CVD), wobei der Druck in der Arbeitskammer typisch unter 1 kPa liegt, und bei Bedarf mindestens eine reaktive Komponente in fester und/oder flüssiger und/oder gasförmiger Form in den Plasmastrahl injiziert wird.

Mit Vorteil weist die erzeugte Oxidschicht eine Porosität von weniger als 3 % oder weniger als 1 % auf und/oder wird zu mehr als 90 % oder mehr als 95 % aus einem thermisch stabilen Oxid, d.h. einem Oxid wie beispielsweise α-Al₂O₃ gebildet, das bei den Einsatzbedingungen des Substrates thermisch stabil ist.

In einer weiteren vorteilhaften Ausführungsform wird die mindestens eine Wärmedämmschicht aus keramischem Material hergestellt, wobei das keramische Material beispielsweise aus stabilisiertem Zirkonoxid, insbesondere mit Yttrium, Cer, Scandium, Dysprosium oder Gadolinium stabilisiertem Zirkonoxid, bestehen und/oder stabilisiertes Zirkonoxid, insbesondere mit Yttrium, Cer, Scandium, Dysprosium oder Gadolinium stabilisiertes Zirkonoxid, als Bestandteil enthalten kann.

In einer vorteilhaften Ausführungsvariante wird die mindestens eine Wärmedämmschicht mittels thermischen Plasmaspritzens bei einem Druck in der Arbeitskammer von mehr als 50 kPa aufgebracht und/oder mittels Niederdruck-Plasmaspritzen (LPPS) bei einem Druck in der Arbeitskammer von 5 kPa bis 50kPa.

In einer weiteren vorteilhaften Ausführungsvariante wird die mindestens eine Wärmedämmschicht mittels Plasma Spray - Physical Vapor Deposition (PS-PVD) bei einem Druck in der Arbeitskammer von weniger als 5 kPa und typisch weniger als 1 kPa aufgebracht, wobei das keramische Material beispielsweise in ein den Pulverstrahl defokussierendes Plasma injiziert werden kann. Vorteilhafterweise wird das keramische Material im Plasmastrahl wenigstens teilweise verdampft, so dass zum Beispiel mindestens 15 Gew. % oder mindestens 20 Gew. % in die Dampfphase übergehen, um eine Wärmedämmschicht mit kolumnarer Struktur zu erzeugen.

In einer weiteren vorteilhaften Ausführungsform werden die Richtung des Plasmastrahls und/oder der Abstand des Plasmabrenners vom Substrat gesteuert. Auf diese Weise kann der Plasmastrahl beispielsweise beim Reinigen der Substratoberfläche und/oder beim Erwärmen der Substratoberfläche und/oder beim Aufbringen der mindestens einen Wärmedämmschicht über die Substratoberfläche geführt werden.

Weiter umfasst die Erfindung ein Substrat, hergestellt mit dem oben beschriebenen Verfahren oder einer der oben beschriebenen Ausführungsformen und -varianten.

Das Verfahren zum Herstellen eines Wärmedämmschichtaufbaus gemäss vorliegender Erfindung hat den Vorteil, dass dank der Reinigung der Substratoberfläche mittels Lichtbogen Verunreinigungen und Oxidschichten, wie beispielsweise spontan sich bildende natürliche Oxidschichten, vollständig entfernt werden können, und im Anschluss daran auf der gereinigten Substratoberfläche eine Oxidschicht unter kontrollierten Bedingungen erzeugt werden kann. Auf diese Weise kann eine bessere Haftung des Wärmedämmschichtaufbaus auf der Substratoberfläche erzielt werden, als dies mit einer gemäss WO 03/087422 A1 hergestellten Wärmedämmschicht möglich ist. Darüber hinaus ist es möglich, mit einem erfindungsgemäss hergestellten Wärmedämmschichtaufbau das Wachstum von Metalloxiden im Betrieb zu verlangsamen und eine verbesserte Temperaturwechselbeständigkeit des gesamten Wärmedämmschichtsystems, in dem der Wärmeschichtaufbau eingesetzt wird, zu erreichen.

Die obige Beschreibung von Ausführungsformen und -varianten dient lediglich als Beispiel. Weitere vorteilhafte Ausführungsformen gehen aus den abhängigen Ansprüchen und der Zeichnung hervor. Darüber hinaus können im Rahmen der vorliegenden Erfindung auch einzelne Merkmale aus den beschriebenen oder gezeigten Ausführungsformen und -varianten miteinander kombiniert werden, um neue Ausführungsformen zu bilden.

Im Folgenden wird die Erfindung an Hand der Ausführungsbeispiele und an Hand der Zeichnung näher erläutert. Es zeigen:
- Fig. 1: ein Ausführungsbeispiel einer Plasmabeschichtungsanlage zum Herstellen eines Wärmedämmschichtaufbaus gemäss vorliegender Erfindung.
- Fig. 2: ein Ausführungsbeispiel eines Wärmedämmschichtsystems mit einem Wärmedämmschichtaufbau hergestellt gemäss vorliegender Erfindung, und
- Fig. 3: ein Ausführungsbeispiel eines Wärmedämmschichtaufbaus hergestellt gemäss vorliegender Erfindung auf einem beliebigen metallischen Substrat.

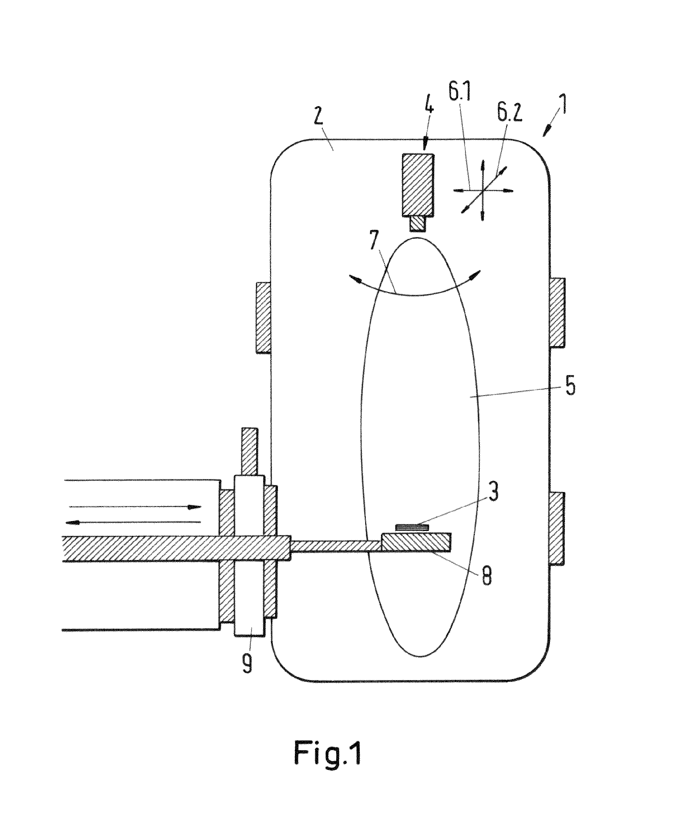

Fig. 1 zeigt ein Ausführungsbeispiel einer Plasmabeschichtungsanlage zum Herstellen eines Wärmedämmschichtaufbaus gemäss vorliegender Erfindung. Die Plasmabeschichtungsanlage 1 umfasst eine Arbeitskammer 2 mit einem Plasmabrenner 4 zur Erzeugung eines Plasmastrahls 5, eine gesteuerte Pumpvorrichtung, die in Fig. 1 nicht gezeigt ist, und die mit der Arbeitskammer 2 verbunden ist, um den Druck in der Arbeitskammer einzustellen und einen Substrathalter 8 zum Halten des Substrates 3. Der Plasmabrenner 4, der zum Beispiel als DC-Plasmabrenner ausgebildet sein kann, hat vorteilhafterweise eine zugeführte elektrische Leistung von wenigstens 60 kW, 80 kW oder 100 kW, um ein Plasma mit genügend hoher spezifischer Enthalpie zu erzeugen, so dass Wärmedämmschichten mit kolumnarer Struktur hergestellt werden können. Der Druck in der Arbeitskammer 2 ist zweckmässigerweise zwischen 2 Pa und 100 kPa oder zwischen 5 Pa und 20 kPa einstellbar. Bei Bedarf kann die Plasmabeschichtungsanlage 1 zusätzlich eine oder mehrere Injektionsvorrichtungen umfassen, um eine oder mehrere Komponenten in fester, flüssiger und/oder gasförmiger Form in das Plasma oder in den Plasmastrahl zu injizieren.

Typischerweise ist der Plasmabrenner mit einer Stromversorgung, zum Beispiel einer Gleichstromversorgung für einen DC-Plasmabrenner, und/oder mit einer Kühlvorrichtung und/oder mit einer Plasmagasversorgung verbunden und fallweise mit einer Versorgung für flüssige und/oder gasförmige reaktive Komponenten und/oder einer Fördervorrichtung für Spritzpulver oder Suspensionen. Das Prozess- oder Plasmagas kann beispielsweise Argon, Stickstoff, Helium oder Wasserstoff oder eine Mischung von Ar oder He mit Stickstoff und/oder Wasserstoff enthalten beziehungsweise aus einem oder mehreren dieser Gase bestehen.

In einer vorteilhaften Ausführungsvariante ist der Substrathalter 8 als verschiebbarer Stabhalter ausgeführt, um das Substrat aus einer Vorkammer durch eine Dichtungsschleuse 9 in die Arbeitskammer 2 zu bewegen. Der Stabhalter ermöglicht zusätzlich, das Substrat falls erforderlich während der Behandlung und/oder Beschichtung zu drehen.

In einer weiteren vorteilhaften Ausführungsvariante umfasst die Plasmabeschichtungsanlage 1 zusätzlich eine gesteuerte Verstellvorrichtung für den Plasmabrenner 4, die in Fig. 1 nicht gezeigt ist, um die Richtung des Plasmastrahls 5 und/oder den Abstand des Plasmabrenners vom Substrat 3 zu steuern, beispielsweise in einem Bereich von 0.2 m bis 2 m oder 0.3 m bis 1.2 m. Fallweise können in der Verstellvorrichtung eine oder mehrere Schwenkachsen vorgesehen sein, um Schwenkbewegungen 7 auszuführen. Darüber hinaus kann die Verstellvorrichtung auch zusätzliche lineare Verstellachsen 6.1, 6.2 umfassen, um den Plasmabrenner 4 über unterschiedlichen Bereichen des Substrats 3 anzuordnen. Lineare Bewegungen und Schwenkbewegungen des Plasmabrenners erlauben eine Steuerung der Substratbehandlung und -beschichtung, beispielsweise um ein Substrat über die gesamte Fläche gleichmässig vorzuheizen, oder um auf der Substratoberfläche eine gleichmässige Schichtdicke und/oder Schichtqualität zu erzielen.

Ein Ausführungsbeispiel des erfindungsgemässen Verfahrens zum Herstellen eines Wärmedämmschichtaufbaus auf einer Substratoberfläche wird im Folgenden an Hand der Figuren 1, 2 und 3 beschrieben. In dem Verfahren wird eine Arbeitskammer 2 mit einem Plasmabrenner 4 zur Verfügung gestellt, ein Plasmastrahl 5 erzeugt, indem ein Plasmagas durch den Plasmabrenner geleitet und in demselben mittels elektrischer Gasentladung und/oder elektromagnetischer Induktion und/oder Mikrowellen aufgeheizt wird, und der Plasmastrahl 5 auf die Oberfläche eines in die Arbeitskammer 2 eingebrachten Substrates 3 gelenkt. In dem Verfahren wird zusätzlich zwischen dem Plasmabrenner 4 und dem Substrat 3 eine Spannung angelegt, um zwischen dem Plasmabrenner und dem Substrat einen Lichtbogen zu erzeugen, und die Substratoberfläche mittels des Lichtbogens gereinigt, wobei das Substrat nach dem Lichtbogenreinigen in der Arbeitskammer verbleibt. Auf der derart gereinigten Substratoberfläche wird eine Oxidschicht 11 mit einer Dicke von 0.02 µm bis 5 µm oder 0.02 µm bis 2 µm erzeugt und in einem weiteren Schritt mittels eines Plasmaspritzverfahrens mindestens eine Wärmedämmschicht 12 aufgebracht. Vorteilhafterweise verbleibt das Substrat 3 während der Herstellung des Wärmedämmschichtaufbaus in der Arbeitskammer 2.

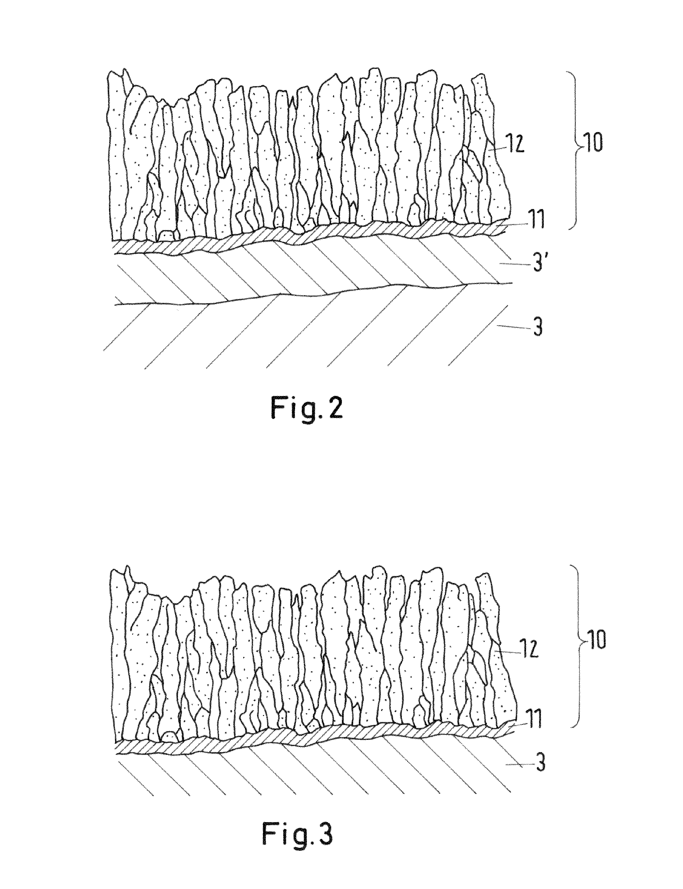

In einer typischen Ausführungsvariante ist das Substrat 3 und/oder die Substratoberfläche metallisch, wobei das Substrat beispielsweise eine Turbinenschaufel aus einer Ni- oder Co-Legierung sein kann, und die Substratoberfläche typisch durch eine Haftvermittlerschicht und/oder Heissgaskorrosionsschutzschicht 3', zum Beispiel eine Schicht aus einem Metallaluminid wie NiAl, NiPtAl oder PtAl oder einer Legierung des Typs MCrAlY, mit M = Fe, Co, Ni oder eine Kombination von Ni und Co, gebildet wird. Bei Bedarf kann zudem eine Sperrschicht zwischen dem Substrat 3 und der Haftvermittlerschicht und/oder Heissgaskorrosionsschutzschicht 3' vorgesehen werden (nicht gezeigt in den Figuren 2 und 3), wobei die Sperrschicht mit Vorteil metallisch ausgebildet ist und beispielsweise NiAl oder NiCr enthalten kann.

Das Aufbringen der Sperrschicht und/oder Haftvermittlerschicht und/oder Heissgaskorrosionsschutzschicht kann, falls gewünscht, im Rahmen des Verfahrens zum Herstellen eines Wärmedämmschichtaufbaus erfolgen. In einer vorteilhaften Ausführungsform wird die Sperrschicht und/oder Haftvermittlerschicht und/oder Heissgaskorrosionsschutzschicht auf die Substratoberfläche aufgebracht, beispielsweise mittels eines Plasmaspritzverfahrens oder eines anderen geeigneten Verfahrens, und der Wärmedämmschichtaufbau fortgesetzt, indem, wie oben stehend beschrieben, die so erzeugte Substratoberfläche mittels Lichtbogen gereinigt wird und, ohne das Substrat 3 nach dem Lichtbogenreinigen aus der Arbeitskammer 2 zu entfernen, auf der derart gereinigten Substratoberfläche eine Oxidschicht 11 mit einer Dicke von typisch 0.02 µm bis 5 µm oder 0.02 µm bis 2 µm erzeugt wird und in einem weiteren Schritt mittels eines Plasmaspritzverfahrens mindestens eine Wärmedämmschicht 12 aufgebracht wird.

In einer weiteren vorteilhaften Ausführungsform werden während dem Herstellen des Wärmedämmschichtaufbaus 10 die Zusammensetzung und/oder der Druck der Atmosphäre in der Arbeitskammer 2 kontrolliert und/oder gesteuert. In einer vorteilhaften Ausführungsvariante beträgt der Druck in der Arbeitskammer während des Lichtbogenreinigens der Substratoberfläche weniger als 1 kPa oder weniger als 200 Pa.

In einer weiteren vorteilhaften Ausführungsvariante enthält die Arbeitskammer 2 während der Erzeugung der Oxidschicht 11 Sauerstoff oder ein Sauerstoff enthaltendes Gas. Die Oxidschicht 11 kann beispielsweise thermisch erzeugt werden, indem die Substratoberfläche zum Beispiel durch den Plasmastrahl 5 und/oder mittels C-Strahler und/oder induktiv erwärmt wird.

Wird die Oxidschicht 11 thermisch erzeugt, so werden die Temperatur der Substratoberfläche und/oder der Druck in der Arbeitskammer und/oder der O₂-Partialdruck in der Arbeitskammer vorteilhafterweise wie folgt gewählt:
- Die Temperatur der Substratoberfläche kann zwischen 1040°C und 1120°C, oder zwischen 1070°C und 1110°C betragen.
- Der Druck in der Arbeitskammer kann zwischen 10 Pa bis 2 kPa, oder zwischen 50 Pa und 500 Pa liegen.
- Der O₂-Partialdruck in der Arbeitskammer kann fallweise zwischen 0.1 Pa bis 20 Pa, oder zwischen 1 Pa und 10 Pa liegen.

Wird die Substratoberfläche während der Erzeugung der Oxidschicht 11 ganz oder teilweise durch den Plasmastrahl 5 erwärmt, so beträgt der Gesamtfluss der Plasmagase und des O₂-Gases in einer typischen Anwendung 60 NLPM bis 240 NLMP oder 100 NLMP bis 180 NLMP und der O₂-Gasfluss 1 NLPM bis 20 NLMP oder 2 NLMP bis 10 NLMP, wobei das O₂-Gas normalerweise getrennt vom Plasmagas zugeführt wird.

Die Oxidschicht 11 kann auch mittels PS-PVD oder mittels eines chemischen Prozesses erzeugt werden, beispielsweise mittels PS-CVD, wobei der Druck in der Arbeitskammer typisch unter 1 kPa liegt, z.B. zwischen 20 Pa und 200 Pa, und bei Bedarf mindestens eine reaktive Komponente in fester und/oder flüssiger und/oder gasförmiger Form ins Plasma und/oder in den Plasmastrahl injiziert wird.

Mit Vorteil weist die erzeugte Oxidschicht eine Porosität von weniger als 3 % oder weniger als 1 % auf und/oder besteht zu mehr als 90 % oder mehr als 95 % aus einem thermisch stabilen Oxid, insbesondere zu mehr als 90 % oder mehr als 95 % aus α-Al₂O₃. In einer vorteilhaften Ausführungsvariante besteht die erzeugte Oxidschicht zu 90 % bis 99 % aus α-Al₂O₃ oder zu 94 % bis 98 % aus α-Al₂O₃, wobei der α-Al₂O₃-Gehalt der Oxidschicht beispielsweise mittels Analyse von Mikroschliffen bestimmt werden kann.

In einer weiteren vorteilhaften Ausführungsform wird die mindestens eine Wärmedämmschicht 12 aus keramischem Material hergestellt, beispielsweise aus einem oxidkeramisches Material oder einem Material, das oxidkeramische Komponenten enthält, wobei das oxidkeramische Material beispielsweise ein mit Seltenerden stabilisiertes Zirkoniumoxid ist. Der als Stabilisator verwendete Stoff wird in Form eines Oxids der Seltenerden, beispielsweise Yttrium, Cer, Scandium, Dysprosium oder Gadolinium, dem Zirkoniumoxid beigemischt, wobei im Fall von Yttriumoxid der Anteil typisch 5 bis 20 Gew.-% beträgt.

In einer vorteilhaften Ausführungsvariante wird die mindestens eine Wärmedämmschicht 12 mittels thermischen Plasmaspritzens bei einem Druck in der Arbeitskammer von mehr als 50 kPa aufgebracht und/oder mittels Niederdruck-Plasmaspritzen (LPPS) bei einem Druck in der Arbeitskammer von 5 kPa bis 50kPa.

In einer weiteren vorteilhaften Ausführungsvariante wird die mindestens eine Wärmedämmschicht 12 mittels Plasma Spray - Physical Vapor Deposition (PS-PVD) bei einem Druck in der Arbeitskammer von weniger als 5 kPa und typisch weniger als 1 kPa aufgebracht, wobei das keramische Material beispielsweise in ein den Pulverstrahl defokussierendes Plasma injiziert werden kann. Vorteilhafterweise wird das keramische Material im Plasmastrahl wenigstens teilweise verdampft, so dass zum Beispiel mindestens 15 Gew. % oder mindestens 20 Gew. % in die Dampfphase übergehen, um eine Wärmedämmschicht mit kolumnarer Struktur zu erzeugen. Die Wärmedämmschicht 12 kann dabei durch Abscheiden einer Mehrzahl von Lagen aufgebaut werden. Die gesamte Schichtdicke der Wärmdämmschicht 12 weist typisch Werte zwischen 50 µm und 2000 µm und vorzugsweise Werte von mindestens 100 µm auf.

Zum Aufbringen der Wärmedämmschicht 12 ist ein Plasmabrenner 4 erforderlich, der zum Beispiel als DC-Plasmabrenner ausgebildet sein kann, und der vorteilhafterweise eine zugeführte elektrische Leistung von wenigstens 60 kW, 80 kW oder 100 kW, um ein Plasma mit genügend hoher spezifischer Enthalpie zu erzeugen, so dass mittels PS-PVD Wärmedämmschichten mit kolumnarer Struktur hergestellt werden können.

Damit während des PS-PVD-Verfahrens der Pulverstrahl durch das defokussierende Plasma in eine Wolke aus Dampf und Partikeln umgeformt wird, aus der sich eine Schicht mit der angestrebten kolumnaren Struktur ergibt, muss das pulverförmige Ausgangsmaterial sehr feinkörnig sein. Die Grössenverteilung des Ausgangsmaterials liegt mit Vorteil zu einem wesentlichen Teil im Bereich zwischen 1 µm und 50 µm, vorzugsweise zwischen 3 µm und 25 µm.

In einer weiteren vorteilhaften Ausführungsform werden die Richtung des Plasmastrahls und/oder der Abstand des Plasmabrenners vom Substrat gesteuert. So kann der Plasmastrahl beispielsweise beim Reinigen der Substratoberfläche und/oder beim Erwärmen der Substratoberfläche und/oder Erzeugen der Oxidschicht und/oder beim Aufbringen der mindestens einen Wärmedämmschicht über die Substratoberfläche geführt werden, um eine gleichmässige Behandlung oder Beschichtung zu erzielen.

Ungeachtet des verwendeten Plasmaspritzverfahrens kann es vorteilhaft sein, eine zusätzliche Wärmequelle zu verwenden, um das Aufbringen und/oder Erzeugen der in den oben stehenden Ausführungsformen und -varianten beschriebenen Schichten innerhalb eines vorgegebenen Temperaturbereichs durchzuführen. Die Temperatur wird typisch im Bereich zwischen 800°C and 1300°C vorgegeben, vorteilhafterweise im Temperaturbereich >1000°C. Als zusätzliche Wärmequelle kann beispielsweise ein Infrarotstrahler, z.B. ein Kohlenstoff-Strahler, und/oder ein Plasmastrahl und/oder ein Plasma und/oder eine Induktionsheizung verwendet werden. Dabei kann die Wärmezufuhr der Wärmequelle und/oder die Temperatur des zu beschichtenden Substrats bei Bedarf gesteuert oder geregelt werden.

Vor dem Aufbringen und/oder Erzeugen der in den oben stehenden Ausführungsformen und -varianten beschriebenen Schichten wird das Substrat 3 und/oder die Substratoberfläche normalerweise vorgeheizt, um die Haftung der Schichten zu verbessern. Das Vorheizen des Substrats kann mittels Plasmastrahl erfolgen, wobei der Plasmastrahl 5, der zum Vorheizen weder Beschichtungspulver noch reaktive Komponenten enthält, mit Schwenkbewegungen über das Substrat geführt wird.

Die Figuren 2 und 3 zeigen jeweils ein Ausführungsbeispiel eines Wärmedämmschichtsystems mit einem Wärmedämmschichtaufbau hergestellt gemäss vorliegender Erfindung. Typisch ist das Substrat 3 und/oder die Substratoberfläche metallisch, wobei die Substratoberfläche beispielsweise, wie in Fig. 2 gezeigt, durch eine Haftvermittlerschicht und/oder Heissgaskorrosionsschutzschicht 3', zum Beispiel eine Schicht aus einem Metallaluminid wie NiAl, NiPtAl oder PtAl oder einer Legierung des Typs MCrAlY, mit M = Fe, Co, Ni oder eine Kombination von Ni und Co, gebildet werden kann. Bei Bedarf kann zudem eine Sperrschicht zwischen dem Substrat 3 und der Haftvermittlerschicht und/oder Heissgaskorrosionsschutzschicht 3' vorgesehen werden (nicht gezeigt in den Figuren 2 und 3), wobei die Sperrschicht mit Vorteil metallisch ausgebildet ist und beispielsweise aus NiAl oder NiCr bestehen kann. Die Sperrschicht hat typisch eine Dicke zwischen 1 µm bis 20 µm und die Haftvermittlerschicht und/oder Heissgaskorrosionsschutzschicht 3' typisch eine Dicke zwischen 50 µm und 500 µm.

Das Aufbringen der Sperrschicht und/oder Haftvermittlerschicht und/oder Heissgaskorrosionsschutzschicht kann, falls gewünscht, im Rahmen des Verfahrens zum Herstellen eines Wärmedämmschichtaufbaus erfolgen. In einer vorteilhaften Ausführungsform wird die Sperrschicht und/oder Haftvermittlerschicht und/oder Heissgaskorrosionsschutzschicht auf die Substratoberfläche aufgebracht, beispielsweise mittels eines Plasmaspritzverfahrens oder eines anderen geeigneten Verfahrens, und der Wärmedämmschichtaufbau fortgesetzt, indem, wie oben stehend beschrieben, die so erzeugte Substratoberfläche mittels Lichtbogen gereinigt wird und, ohne das Substrat 3 nach dem Lichtbogenreinigen aus der Arbeitskammer 2 zu entfernen, auf der derart gereinigten Substratoberfläche eine Oxidschicht 11 mit einer Dicke von typisch 0.02 µm bis 5 µm oder 0.02 µm bis 2 µm erzeugt wird und in einem weiteren Schritt mittels eines Plasmaspritzverfahrens mindestens eine Wärmedämmschicht 12 aufgebracht wird.

Bei Bedarf kann auf der Wärmedämmschicht 12 zusätzlich eine in den Figuren 2 und 3 nicht gezeigte Glättungsschicht aufgebracht werden, die zum Beispiel aus oxidkeramischem Material wie ZrO₂ oder SiO₂ bestehen und eine Dicke von typisch 0.2 µm bis 50 µm, vorzugsweise 1 µm bis 20 µm aufweisen kann. Die Glättungsschicht wird mit Vorteil mittels PS-PVD aufgebracht, indem beispielsweise eine oder mehrere Komponenten in fester, flüssiger und/oder gasförmiger Form in das Plasma oder in den Plasmastrahl injiziert werden.

Die einzelnen Schritte des Verfahrens zum Herstellen eines Wärmedämmschichtaufbaus auf einer Substratoberfläche werden vorzugsweise in einem einzigen Arbeitszyklus ausgeführt, ohne das Substrat 3 während des Verfahrens aus der Arbeitskammer 2 zu entfernen.

Weiter umfasst die Erfindung ein Substrat, hergestellt mit dem oben beschriebenen Verfahren oder einer der oben beschriebenen Ausführungsformen und -varianten.

Das oben beschriebene Verfahren zum Herstellen eines Wärmedämmschichtaufbaus auf einer Substratoberfläche sowie die zugehörigen Ausführungsformen und -varianten haben den Vorteil, dass auf der gereinigten Substratoberfläche eine hochwertige Oxidschicht, beispielsweise eine α-Al₂O₃-Schicht erzeugt werden kann, dank welcher eine verbesserte Temperaturwechselbeständigkeit des gesamten Wärmedämmschichtsystems erzielt werden kann.

## Patentansprüche

1. Verfahren zum Herstellen eines Wärmedämmschichtaufbaus (10) auf einer Substratoberfläche, wobei
- eine Arbeitskammer (2) mit einem Plasmabrenner (4) zur Verfügung gestellt wird,
- ein Plasmastrahl (5) erzeugt wird, indem ein Plasmagas durch den Plasmabrenner (4) geleitet und in demselben mittels elektrischer Gasentladung und/oder elektromagnetischer Induktion und/oder Mikrowellen aufgeheizt wird, und
- der Plasmastrahl (5) auf die Oberfläche eines in die Arbeitskammer eingebrachten Substrates (3) gelenkt wird,
**dadurch gekennzeichnet, dass**
- zwischen dem Plasmabrenner (4) und dem Substrat (3) eine Spannung angelegt wird, um zwischen dem Plasmabrenner (4) und dem Substrat (3) ein Lichtbogen zu erzeugen, und die Substratoberfläche mittels des Lichtbogens gereinigt wird,
- das Substrat (3) nach dem Lichtbogenreinigen in der Arbeitskammer verbleibt, und auf der derart gereinigten Substratoberfläche eine Oxidschicht (11) mit einer Dicke von 0.02 µm bis 5 µm, insbesondere von 0.02 µm bis 2 µm erzeugt wird, und
- in einem weiteren Schritt mittels eines Plasmaspritzverfahrens mindestens eine Wärmedämmschicht (12) aufgebracht wird.

2. Verfahren nach Anspruch 1, wobei die Substratoberfläche durch eine Haftvermittlerschicht und/oder Heissgaskorrosionsschutzschicht gebildet wird, insbesondere durch eine Schicht aus einer Legierung des Typs MCrAlY, mit M = Fe, Co, Ni oder NiCo, oder aus einem Metallaluminid gebildet wird.

3. Verfahren nach einem der Ansprüche 1 oder 2, wobei das Substrat (3) während dem Herstellen des Wärmedämmschichtaufbaus in der Arbeitskammer (2) verbleibt.

4. Verfahren nach einem der Ansprüche 1 bis 3, wobei während dem Herstellen des Wärmedämmschichtaufbaus die Zusammensetzung und/oder der Druck der Atmosphäre in der Arbeitskammer kontrolliert und/oder gesteuert werden.

5. Verfahren nach einem der Ansprüche 1 bis 4, wobei der Druck in der Arbeitskammer (2) während des Lichtbogenreinigens der Substratoberfläche weniger als 1 kPa beträgt.

6. Verfahren nach einem der Ansprüche 1 bis 5, wobei die Arbeitskammer (2) während der Erzeugung der Oxidschicht (11) Sauerstoff oder ein Sauerstoff enthaltendes Gas enthält.

7. Verfahren nach einem der Ansprüche 1 bis 6, wobei die Oxidschicht (11) thermisch erzeugt wird, insbesondere indem die Substratoberfläche durch den Plasmastrahl (5) erwärmt wird.

8. Verfahren nach einem der Ansprüche 1 bis 6, wobei die Oxidschicht (11) mittels PS-PVD oder mittels PS-CVD erzeugt wird, während der Druck in der Arbeitskammer unter 1 kPa liegt, und wobei insbesondere mindestens eine reaktive Komponente in flüssiger oder gasförmiger Form in den Plasmastrahl (5) injiziert wird.

9. Verfahren nach einem der vorangehenden Ansprüche, wobei die erzeugte Oxidschicht (11) eine Porosität von weniger als 3 %, insbesondere von weniger als 1 % aufweist, und/oder wobei die erzeugte Oxidschicht (11) zu mehr als 90 % oder mehr als 95 % aus einem thermisch stabilen Oxid, insbesondere zu mehr als 90 % oder mehr als 95 % aus α-Al₂O₃, gebildet wird.

10. Verfahren nach einem der vorangehenden Ansprüche, wobei die mindestens eine Wärmedämmschicht aus keramischem Material hergestellt wird.

11. Verfahren nach Anspruch 10, wobei das keramische Material der Wärmedämmschicht aus stabilisiertem Zirkonoxid, insbesondere mit Yttrium, Cer, Scandium, Dysprosium oder Gadolinium stabilisiertem Zirkonoxid, besteht und/oder stabilisiertes Zirkonoxid, insbesondere mit Yttrium, Cer, Scandium, Dysprosium oder Gadolinium stabilisiertes Zirkonoxid, als Bestandteil enthält.

12. Verfahren nach einem der Ansprüche 10 oder 11, wobei mindestens eine Wärmedämmschicht mittels thermischen Plasmaspritzens bei einem Druck in der Arbeitskammer von mehr als 50 kPa aufgebracht wird und/oder mittels Niederdruck-Plasmaspritzens bei einem Druck in der Arbeitskammer von 5 kPa bis 50kPa.

13. Verfahren nach einem der Ansprüche 10 oder 11, wobei mindestens eine Wärmedämmschicht mittels Plasma Spray - Physical Vapor Deposition (PS-PVD) bei einem Druck in der Arbeitskammer von weniger als 5 kPa oder weniger als 1 kPa aufgebracht wird.

14. Verfahren nach Anspruch 13, wobei das keramische Material im Plasmastrahl wenigstens teilweise verdampft wird, um eine Wärmedämmschicht (12) mit kolumnaren Struktur zu erzeugen.

15. Substrat hergestellt mit einem Verfahren nach einem der vorangehenden Ansprüche.
